# EUROPEAN PATENT APPLICATION

(11) **EP 0 601 561 A1**
(43) Date of publication of application: **15.06.1994**
(21) Application number: 93119787.5
(22) Date of filing: 08.12.1993
(51) Int. Cl.: H01L 31/103, H01L 31/0352

(54) **Photoelectric device**

(30) Priority: 08.12.1992 JP 327749/92
(71) Applicant: TERUMO KABUSHIKI KAISHA, Tokyo (JP)
(72) Inventor: Kudo, Takeshi, c/o Terumo Kabushiki Kaisha, Ashigarakami-gun, Kanagawa-ken (JP); Nakaichi, Katsumi, c/o Terumo Kabushiki Kaisha, Ashigarakami-gun, Kanagawa-ken (JP); Komatsu, Kiyoshi, c/o Terumo Kabushiki Kaisha, Ashigarakami-gun, Kanagawa-ken (JP)
(74) Representative: Casalonga, Axel

(57) **Abstract**

A photoelectric device capable of high conversion efficiency is produced from an ordinary single crystal semiconductor substrate instead of an expensive epitaxial wafer. On the obverse surface of the p-type silicon substrate in the area corresponding to the light-receiving surface, an n⁺ layer (14a) is formed by thermal diffusion of phosphorus to give rise to a pn junction. The surface of the p-type silicon substrate opposite to the light-receiving surface is selectively removed by etching to form a diaphragm part (19). As a result, excess series resistance is eliminated and the conversion efficiency is improved. In the depression of the diaphragm part, a metallic reflection film (20) is formed. On the etched surface of the p-type silicon substrate, a p⁺ layer is formed by thermally diffusing boron in a high concentration.

## Description

### BACKGROUND OF THE INVENTION

### Field of the Invention:

This invention relates to a photoelectric device for transforming a light energy into an electric energy by projecting light on a pn junction formed on a semiconductor substrate. More particularly, it relates to a miniature photoelectric device which is used for the purpose of supplying a drive energy as to a micromachine body, a minute actuator in a work module, or a sensor.

### Description of the Prior Art:

Recently, the development of Si micromachining technologies using silicon has been gaining in impetus. Various medical micromachines such as, for example, micropumps and microvalves for controlling minute flow volumes of blood have been proposed.

Incidentally, micromachines body or work modules of the class in question have many minute actuators (drive parts) and sensors packaged therein. For the supply of the drive energy for such an actuator, the most popularly conceived recourse is the transmission of electric power by the use of an electric wire.

The use of an electric wire, however, necessitates layout of at least one pair of hard wires. Particularly when energy is supplied to a number of actuators or similars packed in a narrow space, since the number of hard wires to be used is inevitably increased, the arrangement of peripheral components is rendered difficult and the movements of actuators or similars is limited. Further, the hard wires which are thin and long have the problem of aggravating the loss of electric power in transmission owing to such adverse factors as Joule heat. The supply of electric power via electric wires poses a problem of dubious safety in the medical system.

Heretofore, as a means to effect the supply of electric energy without using such hard wires as mentioned above, a photoelectromagnetic device (JP-A-3-62,305) has been proposed. This photoelectromagnetic element has a photoelectric element, a thin-film coil, and a magnetic circuit formed on one and the same substrate. Though it is required to supply an electric energy to a thin-film magnetic head, a thin-film transformer, or a similar, it is allowed to supply the electric energy produced by the photoelectric device to the coil part without the intervention of a hard wire. The electric power which is obtained by this photoelectromagnetic element is very small. Attempts to obtain electric power in a fair amount by this photoelectromagnetic element require to assign a larger area to the photoelectric element and so as to increase the electric power generated by the photoelectric element itself or to use very intense light for the sake of projection. Sometimes if not always, therefore, this element cannot be satisfactorily used by itself as a power source of the aforementioned micromachines.

When a voltage higher than the voltage obtained by the photoelectric element on the secondary coil side is to be produced by using the thin-film transformer of the disclosed element as a transformer and the coil on the substrate as a primary coil, since an alternating current is required on the primary side coil for the purpose of transformation, the element necessitates in addition to the main body of itself a secondary means or method of some sort intended to convert the light projected on the photoelectric element into an alternating current as by chopping the light, for example. The present photoelectromagnetic element, therefore, cannot be easily used in its unmodified form as an energy source for the micromachine.

The present applicant for patent formerly proposed a photoelectric device which has high conversion efficiency and is ideally used for such miniature devices as micromachines (USSN 08/010,794). This photoelectric device, as illustrated in Fig. 1 and Fig. 2, is formed on an epitaxial wafer 40.

In this photoelectric device, boron is diffused in a high concentration in an n⁻ layer (epitaxial layer) 2 to form a p⁺ area 3 and give rise to a pn junction. Here, the n⁻ layer 2 is adapted to possess a particularly low donor concentration for the purpose of causing a depletion layer to expand to the largest possible depth and enabling the light to be absorbed therein. On the surface of the p⁺ layer 3, an oxide film 4 is formed as an antireflection coating. On the surface of the n⁻ layer 2, phosphorus is selectively diffused to form an n⁺ area 5. Metallic electrodes 6 and 7 for extracting an electric current are disposed around the n⁺ area 5 and the p⁺ area 3.

In this photoelectric device, the pn junction forms a photogenic carrier when it is irradiated with light. In this photogenic carrier, the electrons are passed through the n⁻ layer 2, advanced through an n⁺ layer 1 of low electric resistance, and extracted to the exterior of the device via an n⁺ area 5 and the metallic electrode 7. The n⁺ layer 1 of the epitaxial wafer, therefore, constitutes an indispensable component for the construction designed to lower the internal series resistance of the photoelectric element.

In the photoelectric device proposed formerly as described above, the use of a high-concentration impurity layer (n⁺ layer 1) is indispensable for the purpose of lowering the internal series resistance of the photoelectric element. In the high-concentration impurity layer of this kind, the minority carrier has a short life and the photoelectric current collecting efficiency is low. On the high-concentration impurity layer (n⁺ layer 1), therefore, a low-concentration impurity layer (n⁻ layer 2) is epitaxially grown.

The fact that the material for the substrate is limited to an epitaxial wafer, however, inconveniences an attempt to integrate the substrate and a miniature actuator manufactured with a non-epitaxial wafer, namely a single crystal wafer, into a one-piece element.

The low-concentration impurity layer is an area to be formed by epitaxial growth and has a thickness of about 20 µm at most. Depending on the wavelength of an incident light, therefore, this layer cannot amply absorb the light. The conventional technique does not always have a construction which is fit for securing a high photoelectric efficiency.

One object of this invention, therefore, is to provide a novel photoelectric device.

Another object of this invention is to provide a photoelectric device which is manufactured from an ordinary single crystal semiconductor substrate instead of an expensive epitaxial wafer and nevertheless enabled to acquire a high conversion efficiency and serve ideally to supply an electrode energy to miniature actuators, sensors, etc.

### SUMMARY OF THE INVENTION

The objects described above are accomplished by a photoelectric device for effecting conversion of a light energy into an electric energy by projecting light on a pn junction formed on one of the surfaces of a semiconductor substrate, which photoelectric device is produced by selectively removing from the side of the semiconductor substrate opposite to the side exposed to the incident light an area corresponding to the pn junction thereby imparting to the pn junction a construction having the pn junction disposed on a diaphragm part and, at the same time, forming in an area corresponding to the selectively removed area of the semiconductor substrate a high-concentration impurity layer identical in the pattern of electroconductivity with the semiconductor substrate.

In this photoelectric device, the pn junction disposed in the diaphragm part, on being exposed to an incident light, generates a photoelectromotive force, which can be extracted externally as an electric energy.

The diaphragm part can be formed by selectively removing part of a single crystal semiconductor substrate by etching. The thickness of the diaphragm part can be controlled so that the produced diaphragm part manifests the maximum efficiency depending on the spectrum of the incident light. Specifically for the purpose of enabling the photoelectric device to effect the conversion with high efficiency, the semiconductor substrate is only required to possess a thickness necessary for thorough absorption of light. An excess thickness of the substrate simply brings about a mischievous increase of the component of series resistance. This explains why the excess thickness is required to be removed.

In the photoelectric device of this invention, since the high-concentration impurity layer identical in the form of electroconductivity with the semiconductor is formed on the etched side of the semiconductor substrate seating the diaphragm part, the electric resistance on the surface of the semiconductor substrate opposite to the side exposed to the incident light can be decreased and an ideal ohmic contact can be established with the metallic electrode. Further, the provision of this high-concentration impurity layer results in more efficient extraction of a photoelectric current because this layer imparts a gradient to the potential energy on the surface of the semiconductor substrate and consequently causes the majority carrier to be attracted toward the reverse side and the minority carrier toward the pn junction.

The photoelectric device of this invention is preferable to be so constructed as to cover the etched surface of the diaphragm part with a metallic film. Owing to this construction, the light penetrating the diaphragm part can be reflected back toward the pn junction. In this construction, therefore, the diaphragm part is only required to have a thickness which is roughly one half of the thickness necessary for the absorption of light. The electric resistance offered to the photoelectric current which penetrates the diaphragm part can be decreased and the efficiency of the conversion can be exalted in proportion as the thickness of the diaphragm is decreased.

The photoelectric device of this invention, owing to the construction having the pn junction disposed on the diaphragm part, manifests an effect of realizing extraction of an electric energy at a high conversion efficiency and permitting integration of miniature actuators, sensors, etc. while obviating the necessity of using an expensive epitaxial wafer.

### BRIEF DESCRIPTION OF THE DRAWINGS

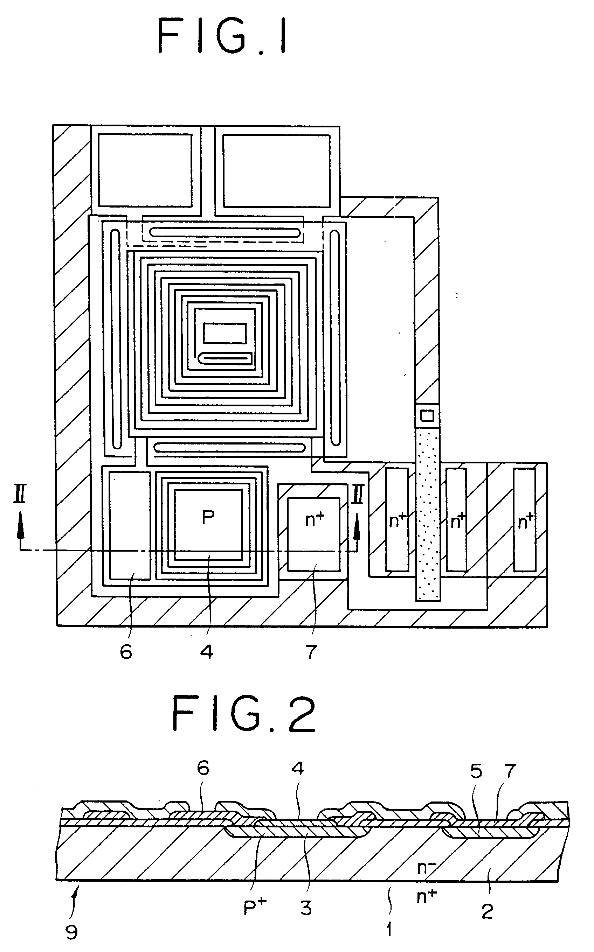

Fig. 1 is a plan view of a conventional photoelectric device.

Fig. 2 is a cross section taken through Fig. 1 along the line II-II.

Fig. 3 is a partially cutaway perspective view illustrating one example of the photoelectric device according with this invention.

Fig. 4 is a cross section taken through Fig. 3 along the line IV-IV.

Fig. 5 is a graph comparing the data obtained of the photoelectric device of the present invention and those of the conventional photoelectric device with respect to the relation between the thickness of a diaphragm part and the conversion efficiency.

Figs. 6A to 6J are cross sections illustrating another example of the photoelectric device of this invention along the sequential steps of the process of manufacture thereof.

### DESCRIPTION OF THE PREFERRED EMBODIMENT

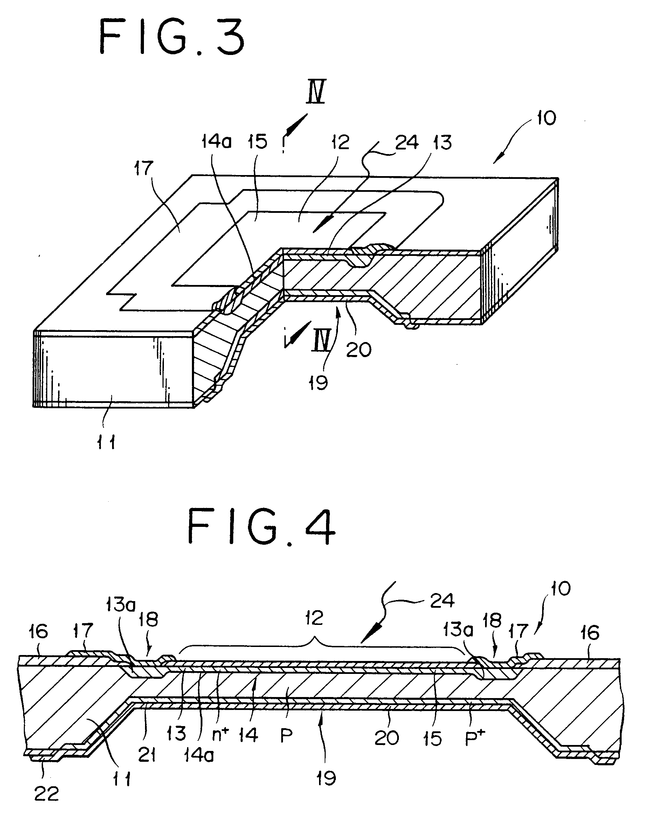

Fig. 3 is a partially cutaway perspective view illustrating the construction of one example of the photoelectric device 10 according with this invention and Fig. 4 is a longitudinal cross section of the construction taken through Fig. 4 along the line IV-IV.

In this photoelectric device 10, an area measuring about 0.5 × 0.5 mm², for example, in one of the main surfaces of a single crystal semiconductor substrate such as, for example, a p-type silicon substrate 11 forms a light-receiving surface 12. In the surface of the p-type silicon substrate 11 corresponding to the light-receiving surface 12, an n⁺ layer 13 is formed by having an n-type impurity substance such as, for example, phosphorus thermally diffused to a surface concentration of 1 × 10¹⁹ cm⁻³. Thus, a pn junction 14 having a junction depth of about 1 µm is formed.

On the surface of the light-receiving surface 12, an antireflection coating 15 of a thickness of 0.16 µm is formed of a film of a material such as, for example, silicon oxide which has a proper refractive index. An insulation film 16 such as of silicon oxide is formed around the antireflection coating 15. An opening (contact hole) 18 is interposed between the insulation film 16 and the antireflection coating 15. In this opening 18, a metallic electrode 17 formed of such a metal as aluminum (Al) is disposed. The metallic electrode 17 is connected to the n⁺ layer 13 via the opening 18. The part of the n⁺ layer 13 adjoining the metallic electrode 17 forms a high-concentration area 13a having a higher concentration of about 1 × 10²⁰ cm⁻³ than in the light-receiving part 12 so as to obtain an ideal ohmic contact with the metallic electrode 17.

The surface (reverse surface) of the p-type silicon substrate 11 opposite to the light-receiving surface 12 is selectively removed by etching to form a diaphragm part 19 which gives rise to a construction having the pn junction 14 overlie the diaphragm part 19. A metallic reflection coating 10 formed of such a metal as aluminum is disposed in the etched side depression of the diaphragm 19. In the thick-wall part around the diaphragm 19, a metallic electrode 22 similarly formed of such a metal as aluminum is disposed.

A p⁺ layer 21 is formed on the etched surface of the p-type silicon substrate 11 seating the diaphragm part 19 for the purpose of lowering the electric resistance in the relevant part and, at the same time, enabling the part to obtain an ohmic contact with the metallic reflection film 20. This p⁺ layer 21 is produced by thermally diffusing such a substance as boron in a high surface concentration of not less than 5 × 10²⁰ cm⁻³. The p⁺ layer 21 imparts a gradient to the potential energy inside the p-type silicon substrate 11 and causes the positive holes to be attracted toward the p⁺ layer 21 side and the electron toward the pn junction interface 14a side.

In this photoelectric device 10, when an incident light 24 of a suitable wavelength such as, for example, a light of a wavelength of 800 nm, impinges on the light-receiving surface 12, a photoelectromotive force is generated in the fields opposed to each other across the pn junction interface 14a. When a load such as a sensor is connected to the metallic electrode 17 and the metallic electrode 22, a closed circuit is formed and an electric current is allowed to flow to the load.

In this photoelectric device 10, the incident light 24 is absorbed severally by the n⁺ layer 13, depletion layer areas (not shown) formed on both sides of the pn junction surface 14a, and the p-type silicon substrate 11 and spent therein in generating photoelectric currents. In this case, the photoelectric currents increase in proportion to the amounts of the incident light to be absorbed. The amounts of the light to be absorbed are increased exponentially, depending on the thicknesses of the layers through which the light passes. Since the n⁺ layer 13 and the depletion layer have very small thicknesses of the order of microns, the light is destined to be mostly absorbed by the p-type silicon substrate 11.

Incidentally, the intensity of the light exponentially decreases in proportion as the depth of penetration of the light increases. In the case of a light having a wavelength of 800 nm, the intensity of the light reaching a depth of some tens of µm in the layer is 1/100 of the intensity of the light existing at the moment of impingement on the surface of the layer. When the thickness of the p-type silicon substrate 11 exceeds the depth mentioned above, the amounts of light to be absorbed and, as a consequence, the amounts of photoelectric currents to be generated are not increased proportionately to the excess of depth. On the contrary, the excess of depth elongates the route extending through the substrate to the metallic electrode 22 and results in an increase in the series resistance.

In the present embodiment, since the area corresponding to the light-receiving part 12 constitutes the diaphragm 19 which is formed in a smaller thickness than any other area of element, the otherwise possible decline of the conversion efficiency due to an extra series resistance can be precluded. Further, since the metallic reflection film 20 is disposed in the depressed part of the diaphragm 19, the light permeating the diaphragm part 19 is reflected on the metallic reflection film 20 and then guided toward the p-type silicon substrate 11. This fact allows the thickness of the diaphragm part 19 necessary for the absorption of light to be further decreased and, as a consequence, permits the series resistance component to be decreased further.

In the photoelectric device 10 of the present embodiment, since the p⁺ layer 21 is formed on the etched surface of the p-type silicon substrate 11, it is enabled to lower the electric resistance in the relevant area and impart a gradient to the potential energy inside the p-type silicon substrate 11. As a result, the positive holes are attracted toward the p⁺ layer 21 side and the electrons toward the pn junction interface 14a side and the extraction of photoelectric currents is efficiently attained.

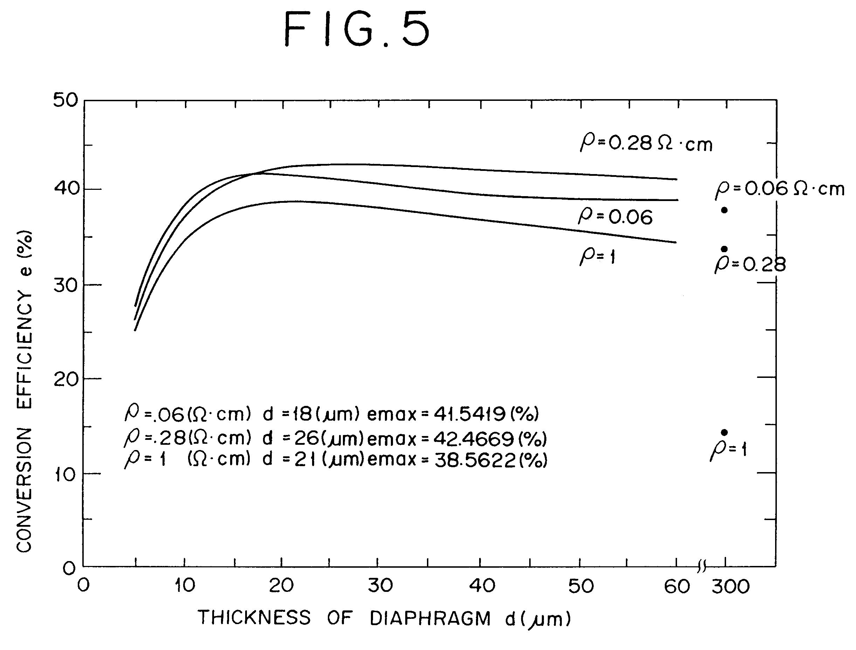

Fig. 5 shows typical data obtained of the relation between the photoelectric conversion efficiency e and the thickness d of the diaphragm part 19 with the resistivity p of the p-type silicon substrate 11 as a parameter in a test using an incident light having a wavelength of 800 nm. For the sake of simplifying the computation of the data, the reflectance of the light-receiving surface 12 was fixed at 0 % and that of the metallic reflection film 20 at 100 % and the p⁺ area was assumed not to entail recombination of a carrier. The numerical values of conversion efficiency reflected in the data were obtained by plotting the maximum values of conversion efficiency at varying thicknesses of diaphragm.

It is clearly noted from Fig. 5 that the conversion efficiency was higher in the presence of the diaphragm part 19 than in the absence of the diaphragm part (d = 300 µm) without reference to the magnitude of the resistivity p of the p-type silicon substrate 11. The thickness d which the diaphragm 19 assumes when the efficiency is highest is variable with the resistivity p of the substrate. The numerical value of the thickness d, as shown in Fig. 3, is 18 µm when the resistivity is 0.06 Ω. cm, 26 µm when the resistivity is 0.28 Ω. cm, and 21 µm when the resistivity is 1.00 Ω. cm. The numerical values of the conversion efficiency e are respectively 41.54 %, 42.47 %, and 38.56 %.

In all cases, the variation of the conversion efficiency e near the peak value thereof is mild. The thickness of the diaphragm 19, therefore, is controlled satisfactorily with the accuracy (within ± 2 µm) which is obtained by the anisotropic wet etching.

Now, another embodiment of this invention will be cited below.

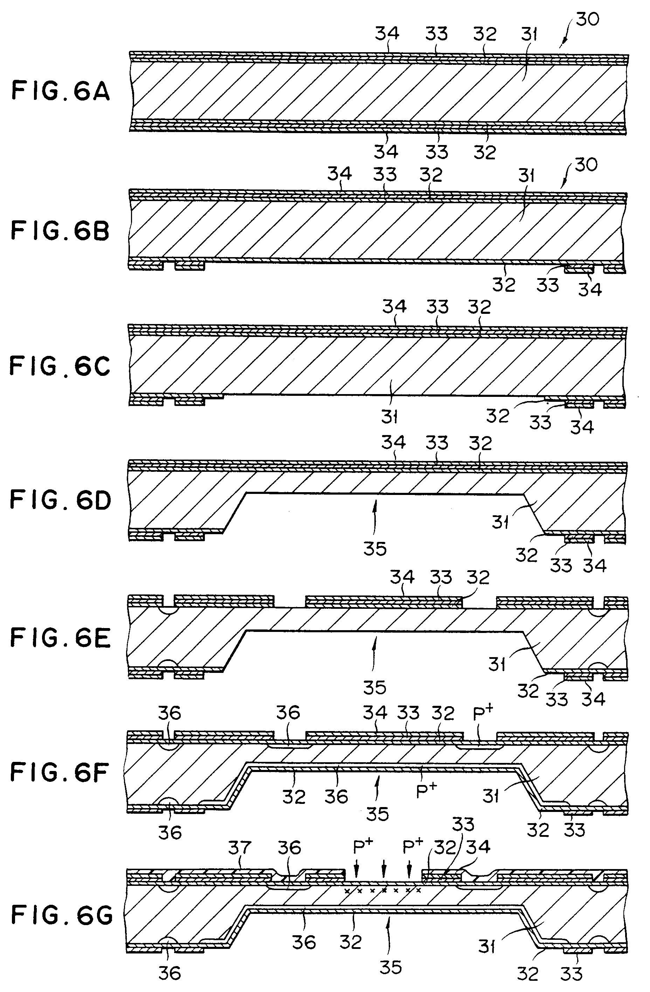

First, a p-type silicon substrate (resistivity p = 1.5 Ω. cm) 31 having the opposite surfaces thereof polished and measuring 300 µm in thickness and 3 mm × 3 mm in area was subjected to pyrogenic oxidation at 1,100 °C for 60 minutes to form an SiO₂ coating 32 having a thickness of 0.57 µm on each of the opposite surfaces of the silicon substrate 31. Then, the coated substrate 31 was treated by the CVD method under a vacuum of 0.4 Torr at 741 °C as supplied continuously with 30 ml of dichlorosilane and 300 ml of ammonia per minute to form a Si₃N₄ coating 33 having a thickness of 0.21 µm on each of the opposite surfaces. The resultant doubly coated substrate was subjected to the CVD method under a vacuum at 850 °C for 40 minutes as supplied continuously with 18 ml of silane and 0.18 liter of nitrogen monoxide per minute to form a pyrogenic oxide coating 34 having a thickness of 0.2 µm on each of the opposite surfaces thereof. Thus, a substrate 30 illustrated in Fig. 6A was obtained.

The substrate 30 was coated on one side thereof with a positive type resist (OFPR-800, product of Tokyo Oka K.K.). Then, it was masked, exposed to light, treated with buffered hydrofluoric acid for one minute to etch the pyrogenic oxide coating 34, and further treated with a mixture of sulfuric acid and hydrogen peroxide to remove the resist coating. The resultant etched substrate was subsequently treated with dilute hydrofluoric acid and further treated with hot phosphoric acid at 160°C for 60 minutes, to etch the Si₃N₄ coating 33 as illustrated in Fig. 6B.

Then, the whole surface on the etched side (the lower side in the bearings of Fig. 6B) of the produced coated substrate was coated with a negative type resist (OMR-83, product of Tokyo Oka K.K.), exposed to light, and treated with buffered hydrofluoric acid for about two minutes to etch the silicon oxide coating 32 and obtain a substrate shown in Fig. 6C. This substrate was treated with dilute hydrofluoric acid to strip the silicon substrate 32 of a natural oxide coating spontaneously formed on the surface thereof, and treated with hydrazine at 117 °C for about 75 minutes to etch the treated side of the substrate to a thickness of 270 µm, form a diaphragm part 35, and obtain a substrate illustrated in Fig. 6D.

The surface (upper side surface) of the substrate of Fig. 6D opposite to the etched part thereof was coated with a negative type resist, masked, exposed to light, and then treated with buffered hydrofluoric acid for about one minutes to strip the surface of the pyrogenic oxide coating 35. Then, the surface was subjected to reactive ion etching under a working pressure of 0.03 Torr at a RF power of 100 W as supplied continuously with carbon tetrafluoride for 10 minutes to remove the Si₃N₄ coating 33. It was subsequently treated with buffered hydrofluoric acid for about two minutes to remove the silicon oxide coating 32 and the resist coating (not shown) and obtain a substrate illustrated in Fig. 6E.

The substrate illustrated in Fig. 6E was set in place in a furnace, treated therein at 1,050 °C for 60 minutes as supplied continuously with 4 liters of nitrogen, 0.03 liter of oxygen, and 0.025 liter of bubbling nitrogen in the liquid of BBr₃ to effect diffusion of boron in the silicon substrate and form a boron-diffused layer 36 in the surface region of the substrate, and further subjected to a surface treatment with a mixture of water and hydrogen fluoride (H₂O : HF = 50 : 1) for one minute to remove by means of etching the uppermost surface region of the borosilicate layer (not shown). Then, the substrate was treated in an oxidizing atmosphere at 1,100 °C for 40 minutes to form a silicon oxide coating 32 and give rise to a substrate possessed of a p⁺ layer 36 as illustrated in Fig. 6F.

The surface (the upper side surface in the bearings of the diagram) of the substrate illustrated in Fig. 6F was coated with a negative type resist 37, masked, exposed to light, and then treated with buffered hydrofluoric acid for about 2.5 minutes to etch the pyrogenic oxide coating and form a pn junction. It was further subjected to reactive ion etching under a working pressure of 0.03 Torr at a RF power of 1,000 W as supplied with carbon tetrafluoride for 10 minutes to remove the Si₃N₄ coating. Subsequently, it was treated with buffered hydrofluoric acid for about two minutes to remove the silicon oxide coating. It was then subjected to phosphorus ion bombardment with an accelerated energy of 40 keV at a dosage of 1 × 10¹⁶ cm⁻² to obtain a substrate illustrated in Fig. 6G.

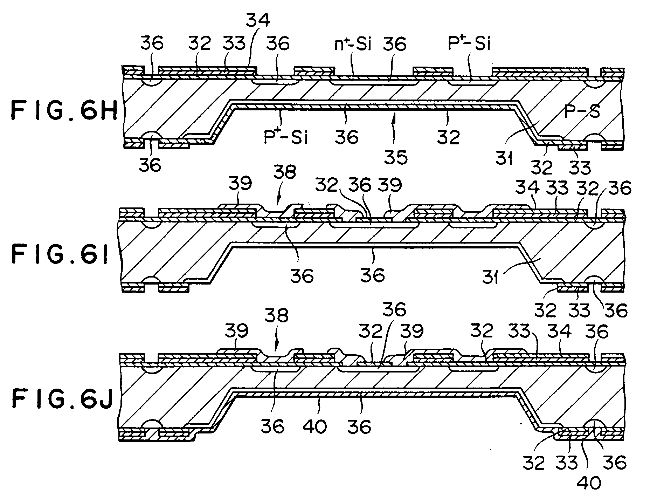

The substrate shown in Fig. 6G was treated at 1,100 °C for 30 minutes to obtain a substrate illustrated in Fig. 6H. Then, the substrate shown in Fig. 6H was coated with a negative type resist, masked, exposed to light, treated with buffered hydrofluoric acid for two minutes to etch the silicon oxide coating 32 and form a contact hole 38, and divested of the resist. The substrate was covered with an aluminum coating 0.5 to 1 µm in thickness by vacuum deposition or spattering and then sintered at a temperature of 300 °C for 10 minutes. The substrate was coated with a positive type resist, masked, exposed to light, treated with an etching liquid (H₂PO₄ : HNO₃ : CH₂COOH : H₃O = 16 : 1 : 2 : 1) at about 40 °C to etch the aluminum coating and form an aluminum electrode 39, and divested of the resist to obtain a substrate illustrated in Fig. 6I. This substrate was sintered in an atmosphere of nitrogen at 800 °C for 10 minutes.

Then, the obverse surface (the upper side surface in the bearings of Fig. 6I) of the substrate was coated with a positive type resist (not shown) and the reverse surface thereof was etched with dilute hydrofluoric acid. The substrate was divested of the resist. On the reverse surface of the substrate, an aluminum coating 0.5 to 1 µm was formed by vacuum deposition or spattering. The substrate was further sintered at a temperature of 400°C for 10 minutes to obtain a device illustrated in Fig. 6J. This device was subjected to dicing and die bonding and the aluminum coatings 39 and 40 were severally subjected to wire bonding. Consequently, a photoelectric device was produced.

This invention has been described with reference to a working example. It is not limited to the example but can be modified variously without departing from the spirit of this invention. The working example has been described as using a p-type silicon substrate 11. Naturally, it is permissible to embody this invention by diffusing a p-type impurity substance in the light-receiving part 12 to form a pn junction 14. The formation of this pn junction 14 is not limited to the method of diffusion. Naturally, it can be effected by the ion injection method.

It is further allowable to form this photoelectric device together with a self-excited circuit, a transformer, and a storage mechanism on one and the same substrate as taught in USSN 08/010,794.

## Claims

1. A photoelectric device for effecting conversion of a light energy into an electric energy by projecting light on a pn junction formed on one of the surfaces of a semiconductor substrate, which photoelectric device is produced by selectively removing from the side of said semiconductor substrate opposite to the side exposed to the incident light an area corresponding to said pn junction thereby imparting to said pn junction a construction having said pn junction disposed on a diaphragm part and, at the same time, forming in an area corresponding to the selectively removed area of said semiconductor substrate a high-concentration impurity layer identical in the pattern of electroconductivity with said semiconductor substrate.

2. A device according to claim 1, wherein the surface of said selectively removed area of said semiconductor substrate is covered with a metallic coating.

3. A device according to claim 2, wherein said metal is aluminum.

4. A device according to claim 1, wherein said semiconductor substrate is made of silicon.

5. A device according to claim 4, wherein said high-concentration impurity layer has boron diffused therein.

6. A device according to claim 5, wherein a n⁺ layer on the light-receiving surface side of said semiconductor substrate is formed by diffusing phosphorus.

7. A device according to claim 6, wherein an antireflection film of silicon oxide is formed on the light-receiving side of said semiconductor substrate.
